# EUROPEAN PATENT APPLICATION

(11) **EP 4 807 989 A1**
(43) Date of publication of application: **16.09.2026**
(21) Application number: 26163843.1
(22) Date of filing: 11.03.2026
(51) Int. Cl.: H03H 17/02, H03H 21/00

(54) **COMPENSATION FILTER CIRCUIT**

(30) Priority: 14.03.2025 US 202563771800 P; 24.02.2026 US 202619548076
(71) Applicant: STMicroelectronics International N.V., 1228 Plan-les-Ouates, Geneva (CH)
(72) Inventor: GUPTA, Sharad, 110059 New Delhi (IN); BAL, Ankur, 201308 Greater Noida (IN); DEBNATH, Chandrajit, 560103 Bengaluru (IN)
(74) Representative: Casalonga

(57) **Abstract**

An example of a compensation filter circuit (600), a method for compensating a processed signal having a frequency response that varies based on one or more environment characteristics, and an electrical system comprising a compensation filter circuit are provided. The example compensation filter circuit includes a base compensation filter (554), a difference compensation filter (550), and scaling circuitry (552). The scaling circuitry generates a scaled difference compensated signal (555) based on a difference compensated signal (551) and environment characteristics, such that an output signal (108) is generated based on the scaled difference compensated signal (550) and a base compensated signal (557).

## Description

Embodiments of the present disclosure relate generally to a compensation filter circuit, and more particularly, to a compensation filter circuit configured to compensate for variations in frequency response of a processed signal based on environment conditions.

Various analog, digital, and mixed signal circuits generate a processed signal based on an input signal. Stable and predictable frequency response of such processing circuits is essential for ensuring reliable and consistent performance across various applications. Instability or unpredictability in the frequency response of a circuit can lead to signal distortion, reduced efficiency, or even system failures. Further, the frequency response of a circuit may be altered based on the operating temperature, voltage, or process (PVT) associated with an operating circuit.

Applicant has identified many technical challenges and difficulties associated with compensating a processed signal for variations in frequency response. Through applied effort, ingenuity, and innovation, Applicant has solved problems related frequency response compensation by developing solutions embodied in the present disclosure, which are described in detail below.

Various embodiments are directed to an example compensation filter circuit, a method for compensating a processed signal comprising frequency response variation based on one or more environment characteristics, and an electrical system comprising a compensation filter circuit.

An example of a compensation filter circuit comprises a base compensation filter, a difference compensation filter, and scaling circuitry. The base compensation filter is configured to generate a base compensated signal based on a processed signal, wherein an amplitude of the processed signal varies based on a frequency of the processed signal, and wherein the base compensation filter is configured to compensate for a baseline frequency response of the processed signal. The difference compensation filter is configured to generate a difference compensated signal based on the processed signal, wherein the difference compensation filter is based on a difference between a maximum frequency response associated with the processed signal and a minimum frequency response associated with the processed signal. The scaling circuitry is configured to generate a scaled difference compensated signal based on the difference compensated signal and one or more environment characteristics, wherein an output signal is generated based on the scaled difference compensated signal and the base compensated signal.

In some embodiments, the base compensation filter comprises a minimum frequency response compensation filter.

In some embodiments, the base compensation filter comprises a maximum frequency response compensation filter.

In some embodiments, the difference compensation filter comprises a fixed difference multiplier configured to generate the difference compensated signal based on multiplying the processed signal and one of a plurality of fixed difference coefficients.

In some embodiments, the difference compensation filter comprises a plurality of fixed difference multipliers, wherein each fixed difference multiplier of the plurality of fixed difference multipliers is configured to multiply a shifted portion of the processed signal and a fixed difference coefficient.

In some embodiments, the base compensation filter comprises a fixed base multiplier, configured to generate the base compensated signal based on multiplying the processed signal and a fixed base coefficient.

In some embodiments, the base compensation filter comprises a plurality of fixed base multipliers, wherein each fixed base multiplier of the plurality of fixed base multipliers is configured to multiply a shifted portion of the processed signal and one of a plurality of fixed base coefficients.

In some embodiments, the compensation filter circuit further comprises an adder configured to generate the output signal based on a summation of the scaled difference compensated signal and the base compensated signal.

In some embodiments, the processed signal is a discrete time signal.

In some embodiments, the difference compensation filter is monotonically increasing.

In some embodiments, the scaling circuitry comprises a scaling multiplier configured to scale the difference compensated signal by a scaling factor.

In some embodiments, the scaling factor is in a range of zero to one, inclusive.

In some embodiments, the one or more environment characteristics include at least one of temperature, semiconductor process, and system voltage.

A method for compensating a processed signal comprising a frequency response that varies based on one or more environment characteristics is provided. In some embodiments, the method comprising: receiving, at a compensation filter circuit, the processed signal; generating a base compensated signal by applying a base compensation filter to the processed signal, wherein the base compensation filter compensates for a baseline frequency response of the processed signal; generating a difference compensated signal by applying a difference compensation filter to the processed signal, wherein the difference compensation filter is based on a difference between a maximum frequency response associated with the processed signal and a minimum frequency response associated with the processed signal; scaling the difference compensated signal based on the one or more environment characteristics to generate a scaled difference compensated signal; and generating an output signal based on the scaled difference compensated signal and the base compensated signal.

In some embodiments, applying the base compensation filter to the processed signal comprises multiplying a plurality of fixed base coefficients by a shifted portion of the processed signal.

In some embodiments, applying the difference compensation filter to the processed signal comprises multiplying a plurality of fixed difference coefficients by a shifted portion of the processed signal.

In some embodiments, scaling the difference compensated signal comprises determining one or more environment characteristics; selecting a scaling factor based on the one or more environment characteristics; and multiplying the scaling factor and the difference compensated signal at a scaling multiplier.

In some embodiments, the base compensation filter comprises a minimum frequency response compensation filter.

In some embodiments, the base compensation filter comprises a maximum frequency response compensation filter.

An electrical system is also provided. The electrical system comprising a signal processing circuit and a compensation filter. The signal processing circuit is configured to receive an input signal and generate a processed signal, wherein the processed signal comprises an amplitude that varies based on a frequency of the processed signal. The compensation filter circuit comprises a base compensation filter, a difference compensation filter, and scaling circuitry. The base compensation filter configured to generate a base compensated signal based on the processed signal, wherein the base compensation filter is configured to compensate for a baseline frequency response of the processed signal; a difference compensation filter configured to generate a difference compensated signal based on the processed signal, wherein the difference compensation filter is based on a difference between a maximum frequency response associated with the processed signal and a minimum frequency response associated with the processed signal; and scaling circuitry configured to generate a scaled difference compensated signal based on the difference compensated signal and one or more environment characteristics; wherein an output signal is generated based on the scaled difference compensated signal and the base compensated signal.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 illustrates a block diagram of an example electrical system comprising a compensation filter circuit in accordance with an example embodiment of the present disclosure.
FIG. 2A depicts an example signal transfer function depicting an example maximum, minimum, and typical frequency response for a processed signal in accordance with an example embodiment of the present disclosure.
FIG. 2B depicts an example signal transfer function depicting example compensation filters for the maximum, minimum, and typical frequency response for the processed signal of FIG. 2A in accordance with an example embodiment of the present disclosure.
FIG. 3 depicts a signal transfer function representing an example difference frequency response between a minimum frequency response and a maximum frequency response of an example processed signal in accordance with an example embodiment of the present disclosure.
FIG. 4 depicts a plurality of example signal transfer functions illustrating a combination of a plurality of scaled versions of a difference compensation signal and an example minimum frequency response in accordance with an example embodiment of the present disclosure.
FIG. 5 illustrates an example block diagram of an example compensation filter circuit for a processed signal in accordance with an example embodiment of the present disclosure.
FIG. 6 illustrates an example block diagram of an example compensation filter circuit comprising a plurality of difference compensation filters and base compensation filters each for a shifted portion of a processed signal in accordance with an example embodiment of the present disclosure.
FIG. 7 depicts a schematic of an example compensation filter circuit in accordance with an example embodiment of the present disclosure.
FIG. 8 illustrates an example process for compensating a processed signal comprising a varied frequency response in accordance with an example embodiment of the present disclosure.

### DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Various example embodiments address technical problems associated with compensating for variations in a processed signal received from a signal processing circuit. As understood by those of skill in the field to which the present disclosure pertains, there are numerous example scenarios in which an electrical system may benefit from a consistent output signal across a range of signal frequencies and environment characteristics.

For example, analog, digital, and mixed signal circuits may generate a processed signal based on an input signal. Such circuits are associated with a frequency response. A frequency response describes the variation in amplitude of an output signal based on a variation in frequency of the input signal. Stable and predictable frequency response of a circuit is essential for ensuring reliable and consistent performance across various applications. Instability or unpredictability in the frequency response of a circuit can lead to signal distortion, reduced efficiency, or even system failures. Further, the frequency response of a circuit may be altered based on the environment characteristics such as the operating temperature, system voltage, or semiconductor process (PVT) associated with a processing circuit.

Compensation filters may be utilized in an electronic system to ensure a stable and predictable frequency response across a range of frequencies and variations in environment characteristics. A compensation filter is a circuit designed to adjust the amplitude of a processed signal based on frequency and environment characteristics to generate a consistent output signal across a range of frequencies. A compensation filter may adjust an output signal based on current PVT, frequency of the signal, and other factors. A compensation filter compensates for unwanted variations such as signal attenuation, phase shifts, or distortions introduced by the electrical components and environmental factors. Compensation filters are commonly used in control systems and communication networks to improve signal quality, counteract system imperfections, and ensure consistent operation across a range of frequencies and environment characteristics.

In some examples, compensation circuits have been implemented by selecting from one of multiple independent filters each filter corresponding to a particular condition (e.g., a minimum condition filter, a maximum condition filter, and a typical condition filter). For improved performance, the number of independent filters may be increased (e.g., K filters). Each independent filter may be implemented by applying a set of coefficients to a shifted portion of the input signal. Storing coefficient values for multiple independent filters may require significant memory space and area. In addition, each coefficient must be applied to the input signal using a variable multiplier. A variable multiplier for each coefficient further requires significant area and resources. The result is a compensation circuit consuming significant area, resources, and power.

The various example embodiments of the present disclosure provide a dynamic compensation filter circuit configured to apply a base compensation filter and a scaled difference compensation filter to a processed signal to compensate for variations in frequency response across a range of frequencies and environment characteristics. For example, in some embodiments, the compensation filter circuit of the present disclosure comprises two fixed compensation filters. A base compensation filter may based on a baseline frequency response of the processed signal and a difference compensation filter. In some embodiments, a baseline frequency response may correspond to a minimum frequency response of the signal processing circuit. In some embodiments, a baseline frequency response may correspond to a maximum frequency response of the signal processing circuit. A second fixed compensation filter may be based on a difference between the minimum frequency response and the maximum frequency response. Since both these filters are fixed, fixed multipliers with fixed coefficients may be used. Fixed multipliers with fixed coefficients may occupy less space and power, reducing the overall size and power consumption of the compensation filter circuit. In addition, less space is required for storing filter coefficients.

To provide an accurate a stable compensated output signal, the difference compensated signal generated by the difference compensation filter may be scaled based on environment characteristics, such as PVT. For example, the compensation filter circuit may determine a scaling factor based on the observed environment characteristics. In some embodiments, the scaling factor may be in a range from zero to one, inclusive. The scaling factor may be multiplied by the difference compensated signal to appropriately scale the difference compensated signal within the range of frequency responses.

Depending on the base compensation filter (e.g., minimum frequency response compensation filter, maximum frequency response compensation filter), the compensated output signal may be determined by combining the scaled difference compensated signal with the base compensated signal. For example, in an instance in which the base compensation filter corresponds to a minimum compensation filter, the scaled difference compensated signal may be added to the base compensated signal. In an instance in which the base compensation filter corresponds to a maximum compensation filter, the scaled difference compensated signal may be subtracted from the base compensated signal.

As a result of the herein described example embodiments, the area and resources required to implement a compensation filter circuit in an electrical system may be greatly reduced. Thus, an accurate, consistent, and stable compensated output signal may be generated utilizing less power and resources.

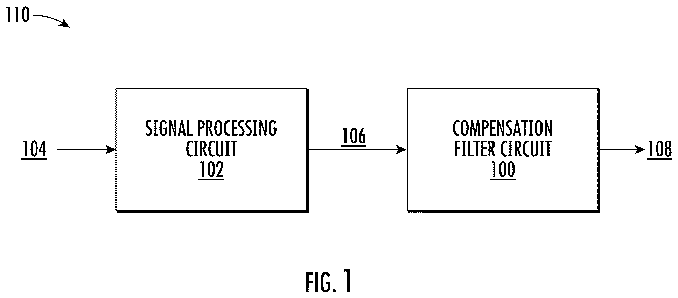

Referring now to FIG. 1, an example electrical system 110 is provided. As depicted in FIG. 1, the example electrical system 110 includes a signal processing circuit 102 and a compensation filter circuit 100. The signal processing circuit 102 is configured to receive an input signal 104 and generate a processed signal 106. The compensation filter circuit 100 is configured to receive the processed signal 106 and generate a compensated output signal 108.

As depicted in FIG. 1, the example electrical system 110 includes a signal processing circuit 102. A signal processing circuit 102 comprises any circuitry including hardware and/or software configured to receive an input signal 104 and perform one or more operations to generate a processed signal 106. Signal processing circuits 102 may comprise any number of passive and active electrical components that may alter, change, or perform operations on the input signal 104. Operations may include filtering operations, buck-boost operations, modulation operations, conversion operations, and the like. In some embodiments, a signal processing circuit 102 may include digital components, analog components, and/or a combination of digital and analog components. In some embodiments, the signal processing circuit 102 may comprise a VGA, modulator, low-pass filter, high-pass filter, analog-to-digital converter, digital-to-analog converter, and/or any combination thereof.

An input signal 104 comprises any time-varying voltage, current, or electromagnetic wave that carries information. The input signal 104 may comprise a control signal, a data signal, a communication signal, and/or the like. An input signal 104 may comprise an analog signal, a digital signal, a discrete time signal, and/or the like.

As further depicted in FIG. 1, the signal processing circuit 102 generates a processed signal 106. A processed signal 106 comprises any time-varying voltage, current, or electromagnetic wave that carries information. The processed signal 106 may be the product of the input signal 104 after the operations of the signal processing circuit 102 are performed. The signal processing circuit 102 may be associated with a frequency response. A frequency response (e.g., signal transfer function) describes the variation in amplitude of the processed signal 106 based on a variation in frequency of the input signal 104.

The electrical components of the signal processing circuit 102 may generate variations in the frequency response of the signal processing circuit 102 based on changes in environment characteristics. Environment characteristics may include temperature, for example, temperature of the environment, electrical components of the signal processing circuit 102, and/or other components of the electrical system 110. Temperature may be monitored by one or more temperature sensors. Environment characteristics may include semiconductor processes. Semiconductor processes may include any characteristics related to the manufacture of the signal processing circuit 102. Characteristics may include manufacturing process, silicon type, doping levels, mask characteristics, etch processes characteristics, component dimensions, voltage ratings, and the like. Voltage characteristics may include system voltages, component voltages, and/or the like.

Due to variations in environment characteristics, the processed signal 106 may exhibit an undesirable frequency response. During processing of the input signal 104, unwanted variations such as signal attenuation, phase shifts, or distortions may be introduced by the electrical components of the signal processing circuit 102 due to environment characteristics. Such unwanted variations may degrade signal quality, consistency, and/or accuracy associated with the processed signal 106. A compensation filter circuit 100 is configured to correct unwanted variations in the processed signal 106 due to variations in frequency and/or environment characteristics.

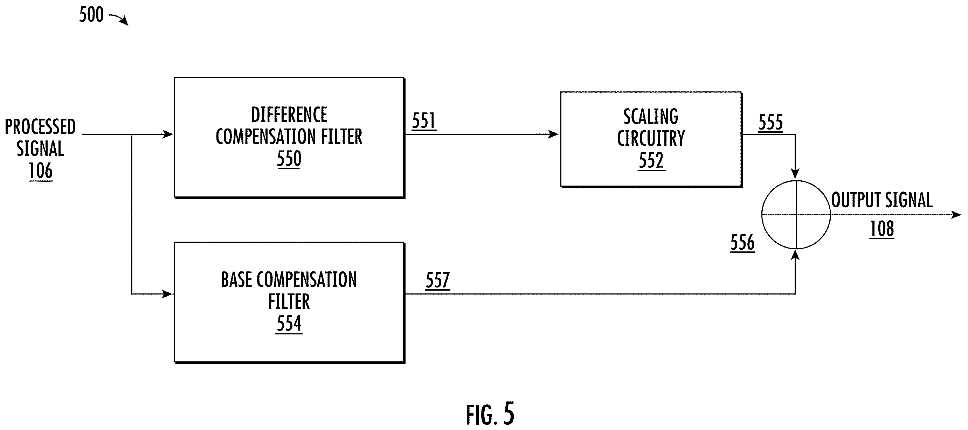

As depicted in FIG. 1, the electrical system 110 comprises a compensation filter circuit 100. A compensation filter circuit 100 comprises circuitry including hardware and/or software configured to determine a state associated with the signal processing circuit 102-including frequency of the input signal 104, temperature, semiconductor process, voltages, and other environmental characteristics-and apply a compensation filter to the processed signal 106 generated by the signal processing circuit 102 to generate a compensated output signal 108 corrected for variations in environment characteristics. As further described in FIG. 5 - FIG. 7, the compensation filter circuit 100 may combine the output of a base compensation filter (e.g., base compensation filter 554 as described in relation to FIG. 5) with a scaled output of a difference compensation filter (e.g., difference compensation filter 550 as described in relation to FIG. 5) to generate the compensated output signal 108.

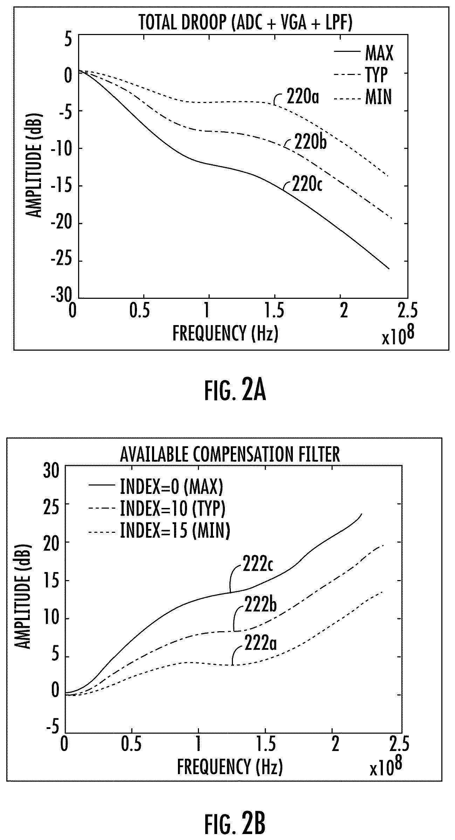

Referring now to FIG. 2A, a plurality of frequency responses (e.g., maximum frequency response 220c, minimum frequency response 220a, typical frequency response 220b) for a processed signal (e.g., processed signal 106) of an example signal processing circuit (e.g., signal processing circuit 102) are provided. Each frequency response 220a - 220c illustrates an amplitude of a processed signal generated by signal processing circuitry over a range of frequencies. As described herein, the frequency response 220a - 220c of the processed signal may vary based on certain environment characteristics. As such, FIG. 2A illustrates a minimum frequency response 220a, a maximum frequency response 220c, and a typical frequency response 220b.

As depicted in FIG. 2A, a minimum frequency response 220a of a processed signal generated by a signal processing circuit may be determined. A minimum frequency response 220a represents a minimum amplitude deviation of the processed signal for each frequency of an input signal in a range of operational frequencies. In some embodiments, the minimum frequency response 220a may be represented as a continuous function based on a plurality of measured processed signals. In some embodiments, the minimum frequency response 220a may be approximated across a range of frequencies based on one or more measured data points.

The minimum frequency response 220a of the signal processing circuit may be determined by any known means. For example, in some embodiments, the minimum frequency response 220a may be determined during initialization and/or testing of an electrical component. The minimum frequency response 220a may be determined based on operating ranges of one or more environment characteristics. For example, a signal processing circuit may be associated with an operating range of temperatures. In some embodiments, the signal processing circuit may be exposed to various temperatures in the operating range and the minimum frequency response 220a for each frequency in the operating range of frequencies may be determined based on the variation in temperature.

As further depicted in FIG. 2A, a maximum frequency response 220c of a processed signal generated by a signal processing circuit may be determined. A maximum frequency response 220c represents a maximum deviation in amplitude of the processed signal for each frequency of an input signal in a range of operational frequencies. In some embodiments, the maximum frequency response 220c may be represented as a continuous function based on a plurality of measured processed signals. In some embodiments, the maximum frequency response 220c may be approximated across a range of frequencies based on one or more measured data points.

The maximum frequency response 220c of the signal processing circuit may be determined by any known means. For example, in some embodiments, the maximum frequency response 220c may be determined during initialization and/or testing of an electrical component. The maximum frequency response 220c may be determined based on operating ranges of one or more environment characteristics. For example, a signal processing circuit may be associated with an operating range of temperatures. In some embodiments, the signal processing circuit may be exposed to various temperatures in the operating range and the maximum frequency response 220c for each frequency in the operating range of frequencies may be determined based on the variation in temperature.

As further depicted in FIG. 2A, a typical frequency response 220b of a processed signal generated by a signal processing circuit may be determined. A typical frequency response 220b is a typical deviation of amplitude of the processed signal for each frequency of an input signal in a range of operational frequencies. In some embodiments, a typical frequency response 220b may be determined based on the minimum frequency response 220a and the maximum frequency response 220c, for example, by averaging the two frequency responses. In some embodiments, the typical frequency response 220b may be calculated based on measurements during initialization and/or testing of an electrical component.

Referring now to FIG. 2B, a plurality of compensation filter functions (e.g., maximum compensation filter function 222c, minimum compensation filter function 222a, typical compensation filter function 222b) for a processed signal (e.g., processed signal 106) of an example signal processing circuit (e.g., signal processing circuit 102) are provided. Each compensation filter function 222a - 222c illustrates an amplitude to be applied to a processed signal to compensate for variations in the processed signal represented by the maximum frequency response 220c, the minimum frequency response 220a, and the typical frequency response 220b as depicted in FIG. 2A.

For example, a compensation filter function 222a - 222c may determined such that when combined with the corresponding frequency response 220a - 220c, the result is a flat or near-flat line. Thus, the minimum compensation filter function 222a is configured to negate the amplitude deviation of the minimum frequency response 220a; the maximum compensation filter function 222c is configured to negate the amplitude deviation of the maximum frequency response 220c; and the typical compensation filter function 222b is configured to negate the amplitude deviation of the typical frequency response 220b.

The minimum compensation filter function 222a, the maximum compensation filter function 222c, and the typical compensation filter function 222b of the signal processing circuit may be determined by any known means. For example, each of the compensation filter functions 222a - 222c may be determined by negating the corresponding frequency response 220a - 220c.

A compensation filter may be designed based on a compensation filter function 222a - 222c. A compensation filter is any circuitry including hardware and/or software configured to compensate a processed signal (e.g., processed signal 106) based on a compensation filter function 222a - 222c. In some embodiments, a compensation filter may be implemented by applying one or more coefficients to a time shifted portion of the processed signal. As a non-limiting example, a compensation filter may comprise ten registers in a shift register, such that ten values of the processed signal are stored in the shift register. To determine the output associated with each time portion, a coefficient is applied to each value stored in the shift register. In some embodiments, applying a coefficient corresponds to multiplying the portion of the processed signal by the coefficient. Once multiplied by the coefficient, each portion is added to generate the output signal for the particular time portion.

As such, a compensation filter may comprise a plurality of coefficients, wherein the coefficients are determined to generate a result corresponding with a compensation filter function 222a - 222c. The coefficients of the compensation filter may depend on the number of coefficients in the compensation filter, the desired accuracy, and/or the corresponding compensation filter function 222a - 222c. Thus, to generate a minimum compensation filter based on the minimum compensation filter function 222a, coefficients are selected such that when a processed signal of a given frequency is received, the processed signal is compensated in correspondence with the minimum compensation filter function 222a.

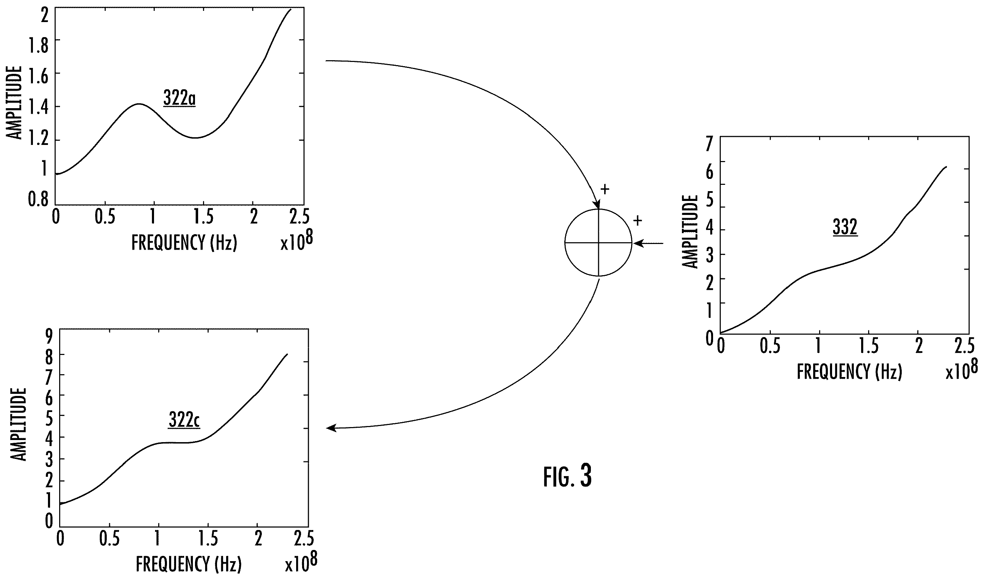

Referring now to FIG. 3, an example difference compensation filter function 332 is depicted. As depicted in FIG. 3, the example difference compensation filter function 332 represents a difference between an example minimum compensation filter function 322a and a maximum compensation filter function 322c. As such, an addition of the difference compensation filter function 332 and the minimum compensation filter function 322a generates a sum equivalent to the maximum compensation filter function 322c. Similarly, a subtraction of the difference compensation filter function 332 from the maximum compensation filter function 322c generates a difference equivalent to the minimum compensation filter function 322a.

The difference compensation filter function 332 may represent an amplitude of a signal for each frequency in a range of frequencies. A difference compensation filter may be defined based on the difference compensation filter function 332. For example, coefficients may be may be determined such that a generated output signal from the difference compensation filter corresponds with the difference compensation filter function 332. Because the difference compensation filter function 332 is fixed for a particular signal processing circuit, the corresponding coefficients of the difference compensation filter based on the difference compensation filter function 332 are fixed. Fixed difference coefficients enable fixed multipliers to be used. Fixed multipliers utilize far less space and power than variable multipliers.

As further depicted in FIG. 3, the difference compensation filter function 332 is monotonically increasing. A monotonically increasing function is a function that always increases, or stays the same, as the input value (e.g., frequency) increases.

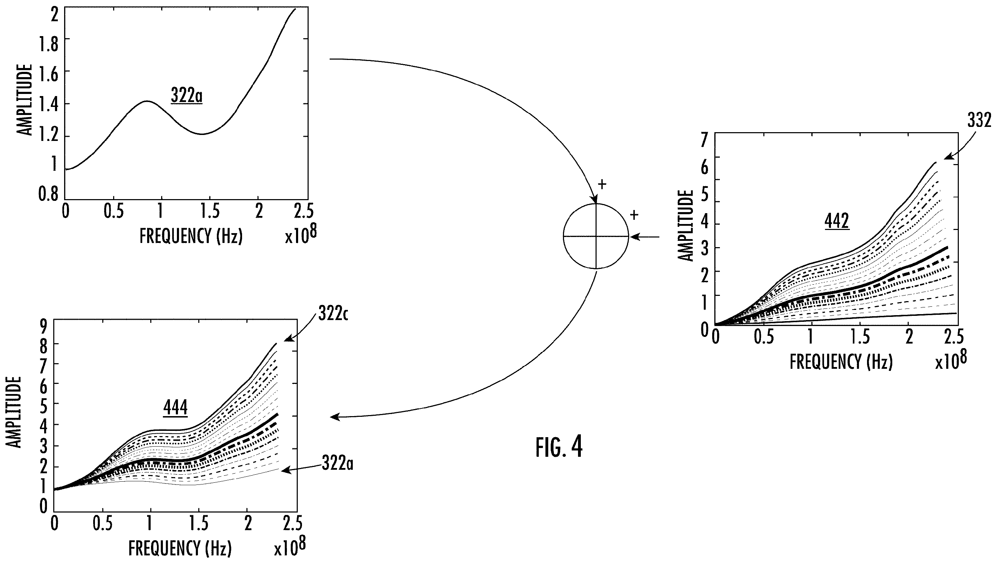

Referring now to FIG. 4, an example scaled difference compensation filter function 442 is depicted. As depicted in FIG. 4, a plurality of scaling factors may be applied to the difference compensation filter function 332 to generate scaled difference compensation filter functions 442. Applying a scaling factor to the difference compensation filter function 332 and adding the resulting scaled difference compensation filter function 442 with the minimum compensation filter function 322a enables a plurality of compensation filter functions 444 between the minimum compensation filter function 322a and the maximum compensation filter function 322c to be realized.

As depicted in FIG. 4, a scaling factor is applied to the difference compensation filter function 332 to generate the plurality of scaled difference compensation filter functions 442. A scaling factor comprises any numeric value that may be applied to, or multiplied by the difference compensation filter function 332 to generate a scaled difference compensation filter function 442 between the minimum compensation filter function 322a and the maximum compensation filter function 322c. For example, in some embodiments, the scaling factor may fall in a range between zero and one. In some embodiments, the scaling factor range may include zero and one. In such an embodiment, a scaling factor of zero may represent the minimum compensation filter function 322a, while a scaling factor of one may represent the maximum compensation filter function 322c. Thus, by utilizing a scaling factor, applied to a difference compensation filter utilizing fixed multipliers, a range of compensation filter functions 444 may be realized using only a single variable multiplier to apply the scaling factor.

Referring now to FIG. 5, an example compensation filter circuit 500 configured to generate a compensated output signal 108 based on a processed signal 106 is provided. As depicted in FIG. 5, the compensation filter circuit 500 includes a difference compensation filter 550 configured to receive the processed signal 106 and generate a difference compensated signal 551. The compensation filter circuit 500 further includes scaling circuitry 552 configured to receive the difference compensated signal 551 and apply a scaling factor to generate a scaled difference compensated signal 555. As further depicted in FIG. 5, the compensation filter circuit 500 includes a base compensation filter 554 configured to receive the processed signal 106 and generate a base compensated signal 557. The compensation filter circuit 500 further includes combination circuitry 556 configured to receive the scaled difference compensated signal 555 and the base compensated signal 557 and generate a compensated output signal 108.

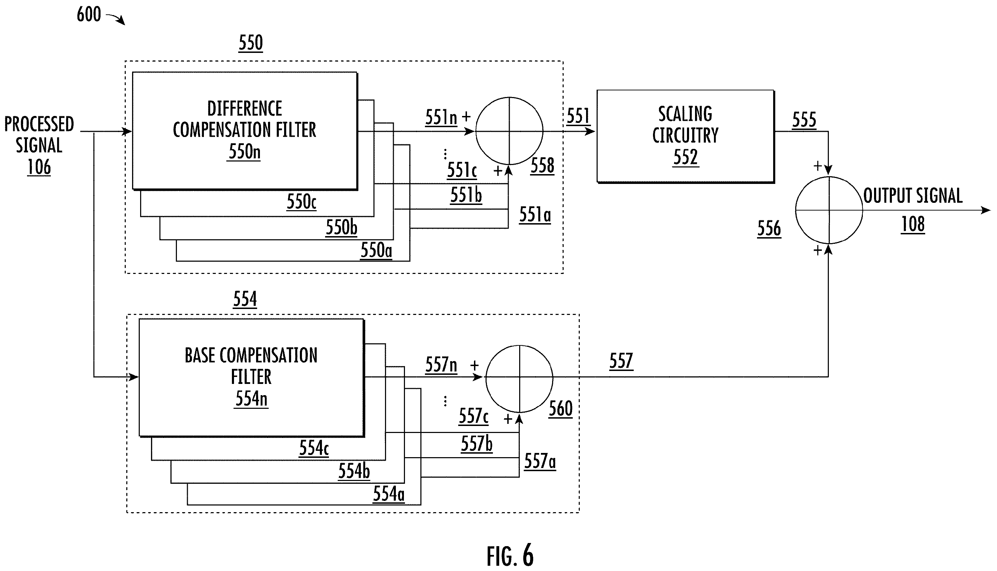

Although only one stage of the compensation filter circuit 500 is depicted in FIG. 5, as described herein and as further shown in FIG. 6, a compensation filter circuit 500 may include a plurality of stages, wherein each stage is configured to operate on a time-shifted portion of the processed signal 106.

As described herein, a compensation filter comprises any circuitry including hardware and/or software configured to compensate a processed signal (e.g., processed signal 106) based on a compensation filter function (e.g., signal transfer function). The compensation filter function defines the output amplitude of the output signal based on the frequency of the processed signal. In general, one or more coefficients are selected such that in an instance in which the one or more coefficients are applied to the processed signal, an output signal based on the compensation filter function is generated. For each point in time, each coefficient is applied to a time shifted portion of the processed signal, for example, by a multiplier. Each product of the time shifted portion of the processed signal and corresponding coefficient is combined to generate the output signal for the compensation filter at the point in time. In this way, the compensation filter function and resulting compensation filter may be designed to counteract variations in the processed signal generated by a signal processing circuit (e.g., signal processing circuit 102).

As depicted in FIG. 5, the compensation filter circuit 500 includes a difference compensation filter 550. The difference compensation filter 550 comprises a compensation filter based on a difference compensation filter function, wherein the difference compensation filter function is determined based on a difference between the minimum compensation filter function and a maximum compensation filter function of a signal processing circuit. The difference compensation filter 550 may be associated with a plurality of coefficients configured to generate a difference compensated signal 551 based on the difference compensation filter function. Each coefficient of the plurality of coefficients may be applied (e.g., multiplied) to a time-shifted portion of the processed signal 106. The resulting products are subsequently summed together to generate the difference compensated signal 551.

Since the difference compensation filter function is fixed, the coefficients associated with the difference compensation filter 550 are also fixed. Thus, the functionality of the difference compensation filter 550 may be implemented with one or more fixed multipliers. For example, a fixed multiplier may be utilized for each coefficient of the difference compensation filter 550.

As further depicted in FIG. 5, the compensation filter circuit 500 includes a base compensation filter 554. The base compensation filter 554 is any compensation filter providing a baseline compensation filter function designed to compensate for a baseline frequency response of a signal processing circuit. In some embodiments, the base compensation filter 554 may be configured to compensate for a minimum frequency response of the processed signal of a signal processing circuit (e.g., minimum frequency response compensation filter). In some embodiments, the base compensation filter 554 may be configured to compensate for a maximum frequency response of the processed signal of a signal processing circuit (e.g., maximum frequency response compensation filter). The base compensation filter 554 may be associated with a plurality of coefficients configured to generate a base compensated signal 557 based on a base compensation filter function (e.g., minimum compensation filter function or maximum compensation filter function). Each coefficient of the plurality of coefficients may be applied (e.g., multiplied) to a time-shifted portion of the processed signal 106. The resulting products are subsequently summed together to generate the base compensated signal 557.

Since the base compensation filter function is fixed, the coefficients associated with the base compensation filter 554 are also fixed. Thus, the functionality of the base compensation filter 554 may be implemented with one or more fixed multipliers. For example, a fixed multiplier may be utilized for each coefficient of the base compensation filter 554.

As further depicted in FIG. 5, the example compensation filter circuit 500 includes scaling circuitry 552. Scaling circuitry 552 comprises any circuitry including hardware and/or software configured to apply a scaling factor to the difference compensated signal 551 based on one or more environment characteristics to generate a scaled difference compensated signal 555. In some embodiments, the scaling circuitry 552 may be configured to multiply a determined scaling factor by the difference compensated signal 551 to determine the scaled difference compensated signal 555. As depicted in FIG. 4, the scaling circuitry 552 may utilize the scaling factor to generate one of a plurality of possible scaled difference compensation filter functions (e.g., scaled difference compensation filter functions 442 as shown in FIG. 4). The scaled difference compensated signal 555 may then be added to a base compensated signal 557 to generate a compensated output signal 108 within a range of compensation filter functions (e.g., compensation filter functions 444) between the minimum compensation filter function and the maximum compensation filter function of the signal processing circuitry.

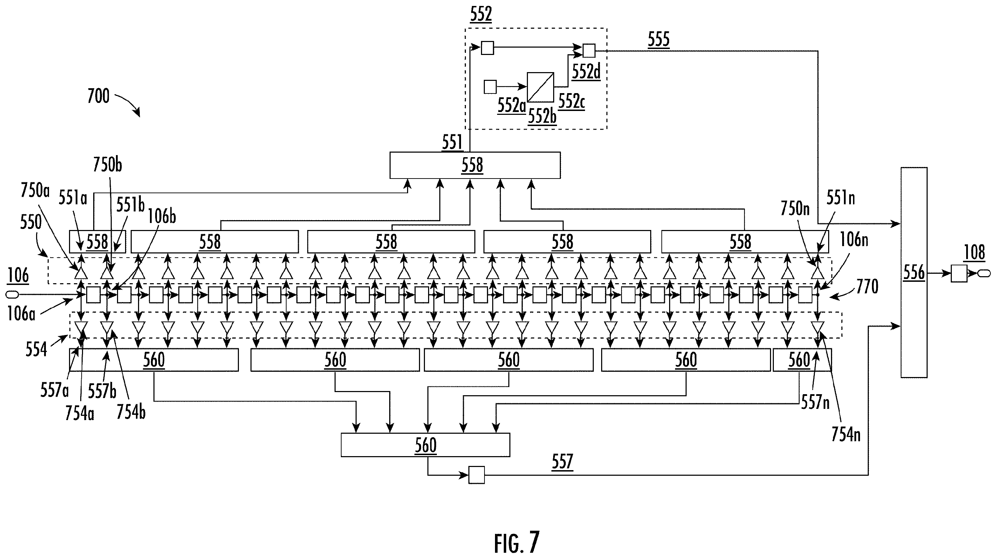

The scaling factor applied by the scaling circuitry 552 may be determined based on the base compensation filter 554; environment characteristics such as temperature, process, and voltage; and other characteristics of the state of the signal processing circuit. For example, in some embodiments, the compensation filter circuit 500 and/or a processing device (e.g., scaling factor selection device 552b as described in relation to FIG. 7) associated with the compensation filter circuit 500 may utilize various data (e.g., sensor data) to determine a state of the signal processing circuitry and an approximate compensation filter function within the range of compensation filter functions required to compensate the processed signal based on the state of the signal processing circuit. In one non-limiting example, the minimum compensation filter function may be based on a minimum operating temperature (e.g., -50 degrees Fahrenheit) and the maximum compensation filter function may be based on a maximum operating temperature (e.g., 300 degrees Fahrenheit). In such an example, the compensation filter circuit 500 or associated processing device may determine the current temperature and select a scaling factor based on the current temperature. In one non-limiting example, in an instance in which the measured temperature is 200 degrees Fahrenheit, the compensation filter circuit 500 or associated processing device may calculate a scaling factor based on the measured temperature, for example: $Scaling Factor = \frac{200 - \left(-50\right)}{300 - \left(-50\right)} = \frac{250}{350} = 0.714$ Thus, a scaling factor of 0.714 may be selected and applied to the difference compensated signal 553. In some embodiments, the scaling factor may be in the range of 0 to 1 inclusive of 0 and 1. Further, in some embodiments, the scaling factor may be adjusted based on the base compensation filter 554. For example, in an embodiment in which the base compensation filter 554 is based on a minimum compensation filter function, the scaling factor may be 0.714, however, in an embodiment in which the base compensation filter 554 is based on a maximum compensation filter function, the scaling factor may be 1 - 0.714, or 0.286.

As further depicted in FIG. 5, the compensation filter circuit 500 further comprises combination circuitry 556. The combination circuitry 556 is any circuitry including hardware and/or software configured to combine the scaled difference compensated signal 555 and the base compensated signal 557 to generate the compensated output signal 108. In some embodiments, the combination circuitry 556 may comprise an adder. For example, in an instance in which the base compensation filter 554 is based on a minimum compensation filter function, the scaled difference compensated signal 555 may be added to the base compensated signal 557 to generate the compensated output signal 108. In an instance in which the base compensation filter 554 is based on a maximum compensation filter function, the scaled difference compensated signal 555 may be subtracted from the base compensated signal 557 to generate the compensated output signal 108.

Referring now to FIG. 6, an example compensation filter circuit 600 is provided. As depicted in FIG. 6, the example compensation filter circuit 600 includes a difference compensation filter 550 comprising a plurality of component difference compensation filters 550a - 550n. During operation, the processed signal 106 is shifted through a shift register such that each of the difference compensation filters 550a - 550n receive a time-shifted portion of the processed signal 106. Each difference compensation filter 550a - 550n is configured to apply a coefficient to the time-shifted portion of the processed signal 106 received at the particular difference compensation filter 550a - 550n during each time cycle, and generate a portion of the difference compensated signal 551a - 551n based on the application of the associated coefficient. In some embodiments, each difference compensation filter 550a - 550n may comprise a fixed multiplier. The portions of the difference compensated signal 551a - 551n are accumulated at combination circuitry 558 to generate a difference compensated signal 551. In this way, a plurality of coefficients are used by the difference compensation filter 550 to implement a particular difference compensation filter function.

As further depicted in FIG. 6, the compensation filter circuit 600 comprises scaling circuitry 552 configured to receive the difference compensated signal 551 and apply a scaling factor to generate a scaled difference compensated signal 555.

As further depicted in FIG. 6, the example compensation filter circuit 600 includes a base compensation filter 554 comprising a plurality of base compensation filters 554a - 554n. During operation, the processed signal 106 is shifted through a shift register such that each of the base compensation filters 554a - 554n receive a time-shifted portion of the processed signal 106. Each base compensation filter 554a - 554n is configured to apply a coefficient to the time-shifted portion of the processed signal 106 received at the particular base compensation filter 554a - 554n during each time cycle, and generate a portion of the base compensated signal 557a - 557n based on the application of the associated coefficient. In some embodiments, each base compensation filter 554a - 554n may comprise a fixed multiplier. The portions of the base compensated signal 557a - 557n are accumulated at combination circuitry 560 to generate a base compensated signal 557. In this way, a plurality of coefficients are used by the base compensation filter 554 to implement a particular base compensation filter function, such as the minimum base compensation filter function or the maximum base compensation filter function.

As further depicted in FIG. 6, the compensation filter circuit 600 further comprises combination circuitry 556. The combination circuitry 556 is configured to combine the scaled difference compensated signal 555 and the base compensated signal 557 to generate the compensated output signal 108. In some embodiments, the combination circuitry 556 may be configured to determine a sum of the scaled difference compensated signal 555 and the base compensated signal 557 to generate the compensated output signal 108. In some embodiments, the combination circuitry 556 may be configured to determine a difference between the scaled difference compensated signal 555 and the base compensated signal 557 to generate the compensated output signal 108.

Referring now to FIG. 7, an example circuit diagram of a compensation filter circuit 700 is provided. As depicted in FIG. 7, a processed signal 106 is received at a shit register 770. The processed signal 106 travels through the shift register 770 such that a portion of the processed signal 106a - 106n is stored at each register of the shift register 770 over time.

As further depicted in FIG. 7, the example compensation filter circuit 700 includes a difference compensation filter 550 comprising a plurality of fixed multipliers 750a - 750n (e.g., fixed difference multipliers). Each fixed multiplier 750a - 750n is configured to apply a coefficient of the difference compensation filter 550 to the corresponding portion of the processed signal 106a - 106n received at the fixed multiplier 750a - 750n during each time period. Fixed multipliers are smaller and consume less power than variable multipliers. Since fixed multipliers 750a - 750n may be used to implement the difference compensation filter function, the compensation filter circuit 700 may occupy less space and consume less power than traditional compensation filters.

As further depicted in FIG. 7, the plurality of difference compensated signals 551a - 551n are passed through combination circuitry 558 configured to sum the difference compensated signals 551a - 551n from each fixed multiplier 750a - 750n to generate a difference compensated signal 551.

As further depicted in FIG. 7, the difference compensated signal 551 is received at scaling circuitry 552. As depicted in FIG. 7, the scaling circuitry 552 is configured to receive environment data 552a at a scaling factor selection device 552b. The environment data 552a may comprise any data relevant to the state of a signal processing circuit (e.g., signal processing circuit 102 as described in relation to FIG. 1). For example, environment data 552a may include environment characteristics such as temperature, process, and/or voltage. Environment data 552a may further include other characteristics of the signal processing circuit that may affect the frequency response of a processed signal. In some embodiments, environment data 552a may be received from one or more sensing devices, a memory device, a processing device, or other means.

The scaling factor selection device 552b comprises any circuitry including hardware and/or software configured to receive environment data 552a and determine a scaling factor 552c based on the environment data 552a. In some embodiments, the scaling factor selection device 552b may utilize various data (e.g., sensor data) to determine a state of the signal processing circuitry. Based on the state of the signal processing circuitry, the scaling factor selection device 552b may determine a scaling factor 552c to adjust the difference compensated signal 551, for example, to implement functionality in accordance with an approximate compensation filter function within the range of compensation filter functions for the signal processing circuit.

As further depicted in FIG. 7, the scaling factor selection device 552b generates a scaling factor 552c based on the environment data 552a. In some embodiments, the scaling factor may be a value in the range of 0 to 1, inclusive.

As further depicted in FIG. 7, the scaling circuitry 552 further includes a multiplier 552d (e.g., scaling multiplier) configured to multiply the difference compensated signal 551 and the scaling factor 552c to generate a scaled difference compensated signal 555.

As further depicted in FIG. 7, the example compensation filter circuit 700 includes a base compensation filter 554 comprising a plurality of fixed multipliers 754a - 754n (e.g., fixed base multipliers). Each fixed multiplier 754a - 754n is configured to apply a coefficient of the base compensation filter 554 to the corresponding portion of the processed signal 106a - 106n received at the fixed multiplier 754a - 754n during each time period. Since the difference compensation filter 550 and the base compensation filter 554 utilize the same data, only one shift register 770 is used. Since fixed multipliers 754a - 754n may be used to implement the base compensation filter function, the compensation filter circuit 700 may occupy less space and consume less power than traditional compensation filters.

As further depicted in FIG. 7, the plurality of base compensated signals 557a - 557n are passed through combination circuitry 560 configured to sum the base compensated signals 557a - 557n from each fixed multiplier 754a - 754n to generate a base compensated signal 557.

As further depicted in FIG. 7, the compensation filter circuit 700 comprises combination circuitry 556 configured to combine the scaled difference compensated signal 555 and the base compensated signal 557 to generate the compensated output signal 108.

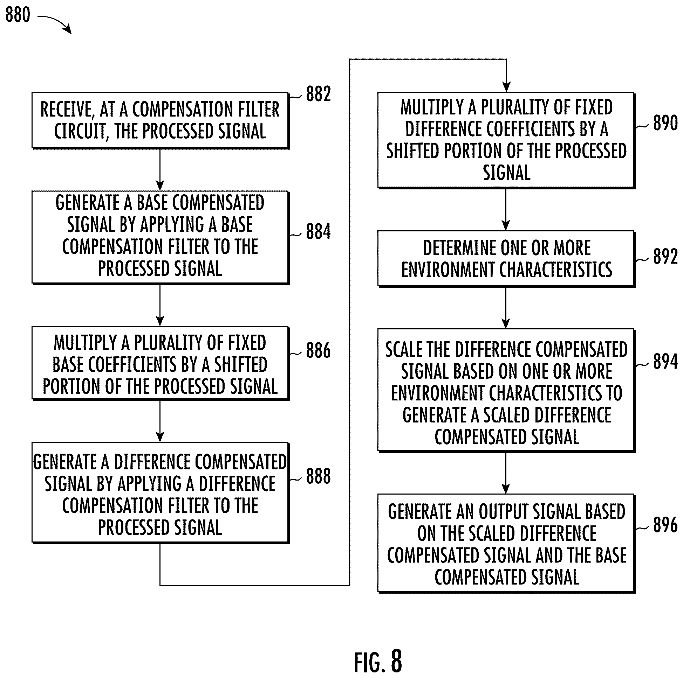

Referring now to FIG. 8, an example process 880 for compensating a processed signal (e.g., processed signal 106) received from a signal processing circuit (e.g., signal processing circuit 102) and comprising a varied frequency response is provided. At block 882, the compensation filter circuit (e.g., compensation filter circuit 100, 500, 600, 700) receives the processed signal. The compensation filter circuit may be electrically connected to the signal processing circuit such that the processed signal may be transmitted via the electrical connection. As described herein, the processed signal may experience variations in frequency response based on environment conditions.

At block 884, the compensation filter circuit generates a base compensated signal (e.g., base compensated signal 557) by applying a base compensation filter (e.g., base compensation filter 554) to the processed signal, wherein the base compensation filter compensates for a baseline frequency response of the processed signal. A baseline frequency response for a signal processing circuit may be determined using any known means. In some embodiments, a baseline frequency response may correspond to a minimum frequency response based on varying environment conditions. In addition, a minimum frequency response may be associated with a minimum signal transfer function determined for a signal processing circuit. In some embodiments, a baseline frequency response may correspond to a maximum frequency response based on varying environment conditions. A maximum frequency response may be associated with a maximum signal transfer function determined for a signal processing circuit.

A base compensation filter comprises one or more coefficients selected to implement a base compensation filter function (e.g., minimum compensation filter function or maximum compensation filter function). When a processed signal passes through the base compensation filter, a base compensated signal is generated. The base compensated signal is altered in accordance with the base compensation filter function associated with the base compensation filter.

At block 886, the compensation filter circuit multiplies a plurality of fixed base coefficients by a shifted portion of the processed signal (e.g., portion of the processed signal 106a - 106n). Since the base compensation filter is based on a baseline frequency response of the processed signal, the coefficients of the base compensation filter are fixed. Thus, fixed multipliers (e.g., fixed multipliers 754a - 754n) may be utilized to determine the product of the shifted portion of the processed signal and the fixed base coefficients.

At block 888, the compensation filter circuit generates a difference compensated signal (e.g., difference compensated signal 551) by applying a difference compensation filter (e.g., difference compensation filter 550) to the processed signal, wherein the difference compensation filter is based on a difference between a maximum frequency response associated with the processed signal and a minimum frequency response associated with the processed signal. A maximum frequency response and minimum frequency response for a signal processing circuit may be determined using any known means. A difference compensation filter function may be determined by computing a difference between the minimum frequency response (e.g., minimum signal transfer function) and the maximum frequency response (e.g., maximum signal transfer function). A difference compensation filter comprises one or more coefficients selected to implement a difference compensation filter function.

At block 890, the compensation filter circuit multiplies a plurality of fixed difference coefficients by a shifted portion of the processed signal (e.g., portion of the processed signal 106a - 106n). Since the difference compensation filter is based on a difference between the minimum and maximum frequency response of the processed signal, the coefficients of the difference compensation filter are fixed. Thus, fixed multipliers (e.g., fixed multipliers 750a - 750n) may be utilized to determine the product of the shifted portion of the processed signal and the fixed difference coefficients.

At block 892, the compensation filter circuit determines one or more environment characteristics. Environment characteristics may include any data relevant to the state of a signal processing circuit, for example, temperature, semiconductor process characteristics, and/or voltage. In some embodiments, the environment characteristics may be received from one or more sensing devices. For example, a temperature sensing device may be queried to determine the temperature of an operating environment. In some embodiments, environment and other state characteristics may be accessed from a memory device associated with the signal processing circuit.

At block 894, the compensation filter circuit scales the difference compensated signal based on the one or more environment characteristics to generate a scaled difference compensated signal (e.g., scaled difference compensated signal 555). Any mechanism may be utilized to determine a scaling factor based on the one or more environment characteristics, including statistical analysis, machine learning techniques, artificial intelligence, or other data analysis techniques. In some embodiments, a processing device (e.g., scaling factor selection device 552b) may be utilized to determine a scaling factor based on the one or more environment characteristics. The scaling factor may be applied to the difference compensated signal to scale the compensated output signal within the range of compensation filter functions for the signal processing circuit, such that the processed signal is adjusted based on the measured and/or observed environment characteristics.

At block 896, the compensation filter circuit generates an output signal (e.g., compensated output signal 108) based on the scaled difference compensated signal and the base compensated signal. The compensation filter circuit may combine the scaled difference compensated signal and the base compensated signal based on the base compensation filter. For example, in an instance in which the base compensation filter implements the minimum compensation filter function of the signal processing circuit, the scaled difference compensated signal and the base compensated signal may be added together. In an instance in which the base compensation filter implements the maximum compensation filter function of the signal processing circuit, the scaled difference compensated signal may be subtracted from the base compensated signal.

While this detailed description has set forth some embodiments of the present invention, the appended claims cover other embodiments of the present invention which differ from the described embodiments according to various modifications and improvements. For example, one skilled in the art may recognize that such principles may be applied to any signal processing device that experiences a variance in output signal amplitude based on measurable environment characteristics.

Within the appended claims, unless the specific term "means for" or "step for" is used within a given claim, it is not intended that the claim be interpreted under 35 U.S.C. 112, paragraph 6.

Use of broader terms such as "comprises," "includes," and "having" should be understood to provide support for narrower terms such as "consisting of," "consisting essentially of," and "comprised substantially of" Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. A compensation filter circuit (100, 500, 600, 700) comprising:
a base compensation filter (554) configured to generate a base compensated signal (557) based on a processed signal (106),
wherein an amplitude of the processed signal (106) varies based on a frequency of the processed signal, and
wherein the base compensation filter (554) is configured to compensate for a baseline frequency response of the processed signal (106);
a difference compensation filter (550) configured to generate a difference compensated signal (551) based on the processed signal (106),
wherein the difference compensation filter (550) is based on a difference between a maximum frequency response associated with the processed signal (106) and a minimum frequency response associated with the processed signal (106); and
scaling circuitry (552) configured to generate a scaled difference compensated signal (555) based on the difference compensated signal (551) and one or more environment characteristics;
wherein an output signal (108) is generated based on the scaled difference compensated signal (551) and the base compensated signal (557).

2. The compensation filter circuit of claim 1, wherein the base compensation filter (554) comprises a minimum frequency response compensation filter,
and/or
wherein the base compensation filter (554) comprises a maximum frequency response compensation filter.

3. The compensation filter circuit of claim 1, wherein the difference compensation filter (550) comprises:
a fixed difference multiplier, configured to generate the difference compensated signal based on multiplying the processed signal and one of a plurality of fixed difference coefficients.

4. The compensation filter circuit of claim 3, wherein the difference compensation filter (550) comprises a plurality of fixed difference multipliers, and wherein each fixed difference multiplier of the plurality of fixed difference multipliers is configured to multiply a shifted portion of the processed signal and a fixed difference coefficient.

5. The compensation filter circuit of claim 1, wherein the base compensation filter (554) comprises:
a fixed base multiplier, configured to generate the base compensated signal based on multiplying the processed signal and a fixed base coefficient.

6. The compensation filter circuit of claim 6, wherein the base compensation filter (554) comprises a plurality of fixed base multipliers, and wherein each fixed base multiplier of the plurality of fixed base multipliers is configured to multiply a shifted portion of the processed signal and one of a plurality of fixed base coefficients.

7. The compensation filter circuit of claim 1, further comprising:
an adder (556) configured to generate the output signal (108) based on a summation of the scaled difference compensated signal (555) and the base compensated signal (557).

8. The compensation filter circuit of claim 1, wherein the scaling circuitry comprises:
a scaling multiplier configured to scale the difference compensated signal by a scaling factor.

9. The compensation filter circuit of claim 8, wherein the scaling factor is in a range of zero to one, inclusive.

10. The compensation filter circuit of claim 1, wherein the one or more environment characteristics include at least one of temperature, semiconductor process, and system voltage.

11. A method for compensating a processed signal comprising a frequency response that varies based on one or more environment characteristics, the method comprising:
receiving, at a compensation filter circuit (100, 500, 600, 700), the processed signal (106);
generating a base compensated signal (557) by applying a base compensation filter (554) to the processed signal (106),
wherein the base compensation filter (554) compensates for a baseline frequency response of the processed signal (106);
generating a difference compensated signal (551) by applying a difference compensation filter (550) to the processed signal (106),
wherein the difference compensation filter (550) is based on a difference between a maximum frequency response associated with the processed signal (106) and a minimum frequency response associated with the processed signal (106);
scaling the difference compensated signal (551) based on the one or more environment characteristics to generate a scaled difference compensated signal (555); and
generating an output signal (108) based on the scaled difference compensated signal and the base compensated signal.

12. The method of claim 11, wherein applying the base compensation filter (554) to the processed signal comprises:
multiplying a plurality of fixed base coefficients by a shifted portion of the processed signal (106).

13. The method of claim 11, wherein applying the difference compensation filter (550) to the processed signal (106) comprises:
multiplying a plurality of fixed difference coefficients by a shifted portion of the processed signal (106),
and/or wherein scaling the difference compensated signal comprises:
determining one or more environment characteristics;
selecting a scaling factor based on the one or more environment characteristics; and
multiplying the scaling factor and the difference compensated signal (551) at a scaling multiplier.

14. The method of claim 11, wherein the base compensation filter (554) comprises a minimum frequency response compensation filter and/or the base compensation filter (554) comprises a maximum frequency response compensation filter.

15. An electrical system comprising:
a signal processing circuit configured to receive an input signal and generate a processed signal (106), wherein the processed signal comprises an amplitude that varies based on a frequency of the processed signal; and
a compensation filter circuit (100, 500, 600, 700) comprising:
a base compensation filter configured to generate a base compensated signal based on the processed signal,
wherein the base compensation filter (554) is configured to compensate for a baseline frequency response of the processed signal (106);
a difference compensation filter (550) configured to generate a difference compensated signal (551) based on the processed signal,
wherein the difference compensation filter (550) is based on a difference between a maximum frequency response associated with the processed signal (106) and a minimum frequency response associated with the processed signal; and
scaling circuitry (552) configured to generate a scaled difference compensated signal (555) based on the difference compensated signal and one or more environment characteristics;
wherein an output signal (108) is generated based on the scaled difference compensated signal (555) and the base compensated signal (557).
